# EUROPÄISCHE PATENTSCHRIFT

(11) **EP 1 157 425 B1**
(45) Veröffentlichungstag und Bekanntmachung des Hinweises auf die Patenterteilung: **29.08.2007**
(21) Anmeldenummer: 00908964.0
(22) Anmeldetag: 01.02.2000
(51) Int. Cl.: H01L 29/739, H01L 21/761

(54) **IGBT MIT PN-ISOLATION**
IGBT WITH PN INSULATION
TRANSISTOR BIPOLAIRE A GRILLE ISOLEE A ISOLATION PN

(30) Priorität: 16.02.1999 DE 19906384
(43) Veröffentlichungstag der Anmeldung: 28.11.2001
(73) Patentinhaber: Infineon Technologies AG, 81669 München (DE)
(72) Erfinder: WERNER, Wolfgang, D-81545 München (DE)
(74) Vertreter: Kottmann, Heinz Dieter
(86) Internationale Anmeldenummer: PCT/DE2000/000281
(87) Internationale Veröffentlichungsnummer: WO 2000/049662

(56) Entgegenhaltungen:
- EP-A- 0 273 030
- EP-A- 0 338 312
- US-A- 5 801 420
- PATENT ABSTRACTS OF JAPAN vol. 16, no. 37 (E-1160), 29. Januar 1992 (1992-01-29) & JP 03 245562 A (SANKEN ELECTRIC CO LTD), 1. November 1991 (1991-11-01)
- PATENT ABSTRACTS OF JAPAN vol. 12, no. 318 (E-650), 29. August 1988 (1988-08-29) & JP 63 081861 A (MITSUBISHI ELECTRIC CORP), 12. April 1988 (1988-04-12)

## Beschreibung

Die vorliegende Erfindung betrifft einen IGBT (Bipolartransistor mit isoliertem Gate) mit PN-Isolation, mit einer niedrig dotierten Driftzone des einen Leitungstyps, die in einem niedrig dotierten Halbleitersubstrat des einen Leitungstyps vorgesehen ist.

Zur dielektrischen Isolation von benachbarten Halbleiterbauelementen in einer monolithisch integrierten Schaltung gibt es bekanntlich die PN-Isolation und die dielektrische Isolation. Bei der PN-Isolation werden benachbarte Bauelemente voneinander durch einen PN-Übergang elektrisch getrennt. So ist es beispielsweise aus der US 5 708 290 bekannt, einen N-Kanal-MOS-Feldeffekttransistor, der in eine N-leitende Wanne eingebettet ist, von einem P-Kanal-MOS-Feldeffekttransistor durch ein P⁺-leitendes Gebiet voneinander elektrisch zu isolieren. Andere Beispiele für solche PN-Isolationen sind aus US 4 881 112 und EP-A1-0 282 734 bekannt.

Die PN-Isolation hat gegenüber der dielektrischen Isolation erhebliche Vorteile, da sie wesentlich einfacher zu realisieren ist: die erforderlichen PN-Ubergänge können ohne weiteres zusammen mit den ohnehin für die Herstellung der einzelnen Bauelemente notwendigen Dotierungsschritten durch Diffusion oder Implantation eingebracht werden, während die dielektrische Isolation die Einbringung von Gräben und deren Auffüllung mit Siliziumdioxid und/oder Siliziumnitrid voraussetzt, also zusätzlich zu den ohnehin vorzunehmenden Dotierungsschritten, die für die PN-Isolation ausgenutzt werden können, weitere Maßnahmen erforderlich macht. Bei IGBT's, die als "Hochseiten-"(high-side) und "Niedrigseiten-"(low-side)-Schalter eingesetzt werden, ist die PN-Isolation jedoch bis heute nicht anwendbar (vgl. hierzu "A Dielectric Isolated High-Voltage IC-Technology For Off-Line Applications" von M. Stoisiek, K.-G. Oppermann, U. Schwalke und D. Takacs in Proceedings of 1995 International Symposium on Power Semiconductor Devices & ICs, Yokohama, Seiten 325-333 und insbesondere Seite 325, linke Spalte, zweiter Absatz), so dass derzeit ausschließlich die aufwendige dielektrische Isolation benutzt wird. Dies beruht letzten Endes darauf, dass bei Einsatz der üblichen PN-Isolation die für die Funktion des IGBT's erforderliche hohe Konzentration an Minoritätsladungsträgern, insbesondere Defektelektronen, in der Driftzone zu unzulässig hohen Substratströmen führen würde.

Im einzelnen ist aus der EP-A-0 338 312 ein IGBT mit einer PN-Isolation bekannt. Dieser IGBT hat eine niedrig dotierte Driftzone des einen Leitungstyps, die in einem Halbleitersubstrat vorgesehen ist, worin zwischen der Driftzone und dem Halbleitersubstrat eine erste hochdotierte Wannenzone des einen Leitungstyps und eine zweite hochdotierte Wannenzone des anderen, zum einen Leitungstyp entgegengesetzten Leitungstyps gelegen sind.

Es ist Aufgabe der vorliegenden Erfindung, einen IGBT anzugeben, bei dem trotz Verwendung einer PN-Isolation das Auftreten von unzulässig hohen Substratströmen vermieden werden kann. Außerdem soll ein Verfahren zum Herstellen eines solchen IGBT geschaffen werden.

Diese Aufgabe wird bei einem IGBT der eingangs genannten Art erfindungsgemäß dadurch gelöst, dass zwischen der Driftzone und dem Halbleitersubstrat eine an der Driftzone anliegende erste hochdotierte Wannenzone des einen Leitungstyps und anliegend an die erste Wannenzone eine an dem Halbleitersubstrat anliegende zweite hochdotierte Wannenzone des anderen, zum einen Leitungstyp entgegengesetzten Leitungstyps vorgesehen sind.

In an sich bekannter Weise sind dabei in der Driftzone eine IGBT-Zelle mit einer Kathode und eine am Rand der Driftzone angeordnete und die IGBT-Zelle umgebende Anode vorgesehen.

Die beiden Wannenzonen sind auf ihrer Oberfläche durch einen Kurzschlussbügel miteinander verbunden. An diesen Kurzschlussbügel kann gegebenenfalls auch noch das niedrig dotierte Halbleitersubstrat angeschlossen sein. Dies gilt beispielsweise dann, wenn der eine Leitungstyp der N-Leitungstyp ist und der IGBT als "Hochseiten"-Schalter eingesetzt wird.

Der erfindungsgemäße IGBT lässt sich infolge seiner PN-Isolation relativ einfach herstellen: die horizontalen Bereiche der beiden Wannenzonen können durch Implantation und/oder Diffusion eingebracht werden, während die vertikalen Bereiche dieser Wannenzonen beispielsweise mittels wenigstens zwei Epitaxieschritten und nachfolgenden Implantationen und/oder Diffusionen zu erzeugen sind. Eine andere Möglichkeit besteht darin, Grabenätzungen vorzunehmen und die so erzeugten Gräben anschließend mit N⁺- oder P⁻-dotiertem polykristallinem Silizium zu füllen und dessen Dotierstoff in die benachbarten monokristallinen Silizium-Halbleiterbereiche ausdiffundieren zu lassen.

Bei dem erfindungsgemäßen IGBT wird für die Isolation der Bauelemente also eine Kombination und entsprechende Beschaltung von PN-Übergängen vorgeschlagen, durch die es möglich ist, den Substratstrom grundsätzlich zu vermeiden, wobei aber die Minoritätsladungsträgerdichte in der Driftzone praktisch nicht beeinflußt wird. Hierzu befindet sich bei dem erfindungsgemäßen IGBT die Kathode bzw. die IGBT-Zelle in der Mitte von beispielsweise einer N⁻-leitenden Driftzone, wenn der eine Leitungstyp der N-Leitungstyp ist. Diese N⁻-leitende Driftzone ist nacheinander von einer N⁺-leitenden ersten Wannenzone und einer P⁺-leitenden zweiten Wannenzone umgeben.

Bereits das an dem Übergang zwischen der N⁺-leitenden ersten Wannenzone und der N⁻-leitenden Driftzone auftretende Driftfeld bewirkt, daß nur ein kleiner Teil der Defektelektronen diese Barriere zu überwinden vermag und in die P⁺-leitende Wannenzone gelangt. Versuche haben gezeigt, daß dieser Anteil unter 1 % liegt.

In der P⁺-leitenden Wannenzone sind aber die Defektelektroden Majoritätsladungsträger. Da nun der PN-Übergang zwischen den beiden Wannenzonen durch den Kurzschlußbügel kurzgeschlossen ist, fließt der Strom zur Kathode ab. In das N⁻-leitende Halbleitersubstrat, das auf dem positivsten Potential der in der Schaltung vorhandenen Potentiale liegt, können damit keine Minoritätsladungsträger gelangen.

Es ist also möglich, einen solchen IGBT als "Hochseiten"-Schalter und als "Niedrigseiten"-Schalter beispielsweise für Brückenanwendungen monolithisch zu integrieren, ohne eine aufwendige dielektrische Isolation einsetzen zu müssen.

Es sei angemerkt, daß in dem obigen Beispiel die Leitungstypen selbstverständlich auch umgekehrt sein können. Ebenso ist es auch möglich, in die jeweiligen Wannen, die durch die beiden Wannenzonen gebildet werden, andere Bauelemente, wie beispielsweise CMOS-Transistoren oder Bipolartransistoren einzubauen.

Abschätzungen zeigen, daß Scheiben mit den erfindungsgemäßen IGBT eine Kostenreduktion bis etwa 50 % gegenüber Scheiben erlauben, in denen herkömmliche IGBT's mit dielektrischer Isolation vorgesehen sind.

Nachfolgend wird ein Ausführungsbeispiel der Erfindung anhand der Zeichnungen näher erläutert. Es zeigen:
- Fig. 1: ein Schnittbild durch ein Ausführungsbeispiel des erfindungsgemäßen IGBT's
- Fig. 2 und 3: Schnittbilder zur Erläuterung von zwei verschiedenen Verfahren zur Herstellung der Wannenzonen bei dem IGBT von Fig. 1.

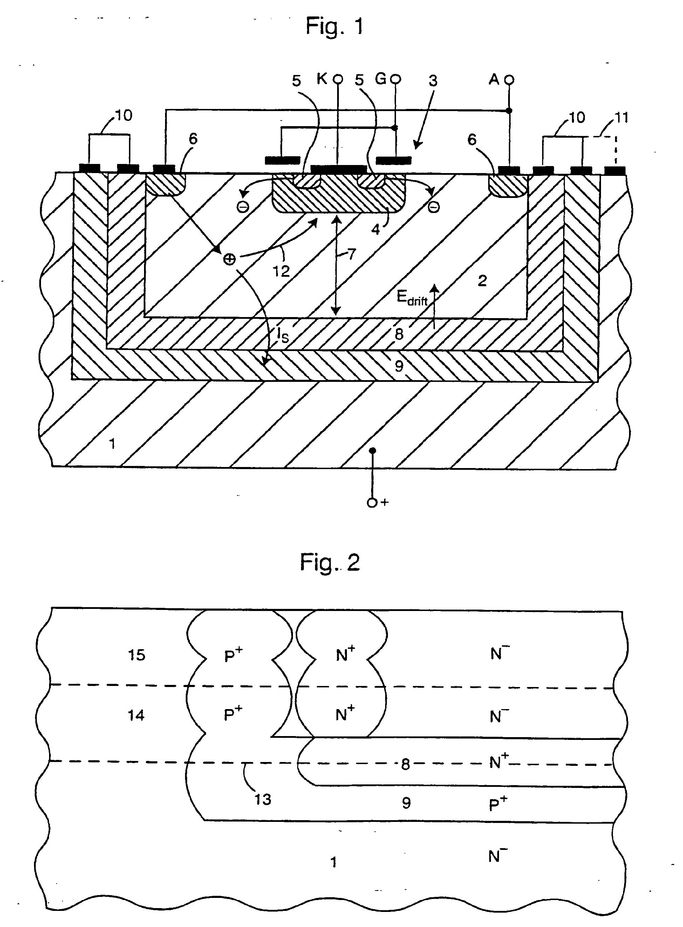

In Fig. 1 ist ein IGBT nach einem Ausführungsbeispiel der vorliegenden Erfindung dargestellt. In einem N⁻-leitenden Halbleiterkörper 1 aus beispielsweise Silizium ist eine N⁻-leitende Driftzone 2 vorgesehen, in der eine IGBT-Zelle 3 mit einer P-leitenden Zone 4 und N⁺-leitenden Zonen 5 angeordnet ist. Die Zonen 4, 5 sind durch eine Kathodenelektrode K kontaktiert, während über den Kanalbereichen der P-leitenden Zone 4 zwischen den Zonen 5 und der Driftzone 2 Gateelektroden G angeordnet sind. Außerdem ist am Rand der Driftzone 2 noch eine P-leitende Ringzone 6 mit einer Anodenelektrode A vorgesehen.

Die Driftzone 2 weist unterhalb der P-leitenden Zone 4 eine aktive Schicht mit einer Dicke dₑₚᵢ auf, wie dies durch einen Doppelpfeil 7 angedeutet ist.

Erfindungsgemäß befinden sich zwischen der Driftzone 2 und dem Halbleitersubstrat 1 eine N⁺-leitende erste Wannenzone 8 sowie eine P⁺-leitende zweite Wannenzone 9. Die beiden Wannenzonen 8, 9 sind durch Kurzschlußbügel 10 miteinander verbunden. Dieser Kurzschlußbügel kann sich bei einem "Hochseiten"-Schalter auch bis zu dem Halbleitersubstrat 1 erstrekken, wie dies durch eine Strichlinie 11 angedeutet ist.

Das an dem Übergang zwischen der N⁺-leitenden ersten Wannenzone 8 und der N⁻-leitenden Driftzone 2 auftretende elektrische Feld E_{dritt} bewirkt, daß nur ein kleiner Teil der Defektelektronen, die aus der P-leitenden Zone 6 austreten, diesen Übergang zu überwinden vermag und in P'-leitende zweite Wannenzone 9 gelangt, so daß allein schon durch diese Maßnahme ein Substratstrom Iₛ sehr klein ist. In der P⁺-leitenden zweiten Wannenzone 9 sind die Defektelektronen Majoritätsladungsträger. Da nun der PN-Übergang zwischen den beiden Wannenzonen 8, 9 durch die Kurzschlußbügel 10 kurzgeschlossen ist, fließt der Strom zu der Kathode ab (vgl. den Pfeil 12), so daß in das N⁻-dotierte Halbleitersubstrat 1, das den positivsten Potentialwert der gesamten Schaltungsanordnung hat, keine Minoritätsladungsträger gelangen.

Es ist_somit auf einfache Weise, d.h. mittels PN-Isolation, möglich, den IGBT als "Hochseiten"-Schalter und als "Niedrigseiten"-Schalter monolithisch zu integrieren, ohne die aufwendige dielektrische Isolation einsetzen zu müssen.

Für eine Sperrspannung von beispielsweise 600 V ist eine Dikke dₑₚᵢ der aktiven Schicht der Driftzone 2 von etwa 35 µm ausreichend. Die Wannenzonen 8, 9 können um beispielsweise eine Größenordnung höher dotiert sein als die Driftzone 2. Es sind aber auch noch höhere Dotierungen der Wannenzonen 8, 9 in bezug auf die Driftzone 2 möglich. Die Driftzone 2 selbst ist in üblicher Weise dotiert.

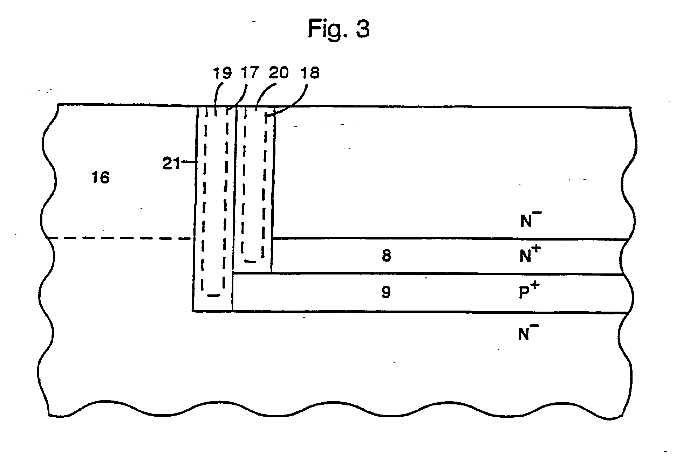

Die Fig. 2 und 3 zeigen, wie der erfindungsgemäße IGBT auf einfache Weise hergestellt werden kann. Dabei werden in den Fig. 2 und 3 für einander entsprechende Teile die gleichen Bezugszeichen wie in Fig. 1 verwendet.

In Fig. 2 werden in ein N⁻-leitendes Halbleitersubstrat 1, das zunächst an einer durch eine Strichlinie 13 angedeuteten Oberfläche endet, durch Diffusion oder Implantation die "Bodenbereiche" der Wannenzonen 8, 9 eingebracht. Sodann werden zwei Epitaxieschichten 14, 15 aufgetragen, wobei nach Anbringen jeder einzelnen Epitaxieschicht 14 bzw. 15 vor Auftragen der nächsten Epitaxieschicht durch Implantation und/oder Diffusion der jeweilige vertikale Bereich der Wannenzonen 8, 9 aufgebaut wird.

In Fig. 3 ist ein anderes Verfahren zum Herstellen der Wannenzonen 8, 9 bei dem erfindungsgemäßen IGBT veranschaulicht. Die Bodenbereiche dieser Wannenzonen 8, 9 werden dabei zunächst in gleicher Weise wie bei dem Ausführungsbeispiel von Fig. 2 erzeugt. Sodann werden aber in eine Epitaxieschicht 16 Gräben 17, 18 eingebracht, die mit P⁺-leitendem polykristallinem Silizium 19 bzw. N⁺-leitendem polykristallinem Silizium 20 gefüllt werden. Aus diesem polykristallinem Silizium 19, 20 wird sodann eine Ausdiffusion vorgenommen, so daß die PN-Übergänge 21 in den monokristallinen Bereich zu liegen kommen.

## Patentansprüche

1. IGBT mit PN-Isolation, mit einer niedrig dotierten Driftzone (2) des einen Leitungstyps, die in einem niedrig dotierten Halbleitersubstrat (1) des einen Leitungstyps vorgesehen ist,
**dadurch gekennzeichnet,**
**dass** zwischen der Driftzone (2) und dem Halbleitersubstrat (1) eine an der Driftzone (2) anliegende erste hochdotierte Wannenzone (8) des einen Leitungstyps und anliegend an die erste Wannenzone (8) eine an dem Halbleitersubstrat (1) anliegende zweite hochdotierte Wannenzone (9) des anderen, zum einen Leitungstyp entgegengesetzten Leitungstyps vorgesehen sind.

2. IGBT nach Anspruch 1,
**dadurch gekennzeichnet,**
**dass** in der Driftzone (2) eine IGBT-Zelle (3) mit einer Kathode (4, 5; K) und eine am Rand der Driftzone (2) angeordnete und die IGBT-Zelle (3) umgebene Anode (6; A) vorgesehen sind.

3. IGBT nach Anspruch 1 oder 2,
**dadurch gekennzeichnet,**
**dass** die beiden Wannenzonen (8, 9) auf ihrer Oberfläche durch einen Kurzschlussbügel (10) miteinander verbunden sind.

4. IGBT nach Anspruch 1 oder 2,
**dadurch gekennzeichnet,**
**dass** die beiden Wannenzonen (8, 9) und das Halbleitersubstrat (1) auf ihren Oberflächen durch einen Kurzschlussbügel (10, 11) miteinander verbunden sind.

5. Verfahren zum Herstellen der Wannenzonen für den IGBT nach einem der Ansprüche 1 bis 4,
**dadurch gekennzeichnet,**
**dass** horizontale Bereiche der Wannenzonen (8, 9) durch Implantation und/oder Diffusion hergestellt werden, und dass vertikale Bereiche der Wannenzonen (8, 9) durch wenigstens zwei Epitaxieschritte (14, 15) mit nachfolgender Implantation und/oder Diffusion hergestellt werden.

6. Verfahren zum Herstellen der Wannenzonen für den IGBT nach einem der Ansprüche 1 bis 4,
**dadurch gekennzeichnet,**
**dass** horizontale Bereiche der Wannenzonen (8, 9) durch Implantation und/oder Diffusion hergestellt werden, und das vertikale Bereiche der Wannenzonen (8, 9) durch Grabenätzung (17, 18) in eine Epitaxieschicht (16) mit anschließender Auffüllung der Gräben mit dotierten polykristallinem Silizium (19, 20) und Ausdiffusion (vgl. 21) hergestellt werden.

## Claims

1. IGBT with PN isolation having a low-doped drift zone (2) of the one conduction type, which is provided in a low-doped semiconductor substrate (1) of the one conduction type, **characterized in that** a first highly doped well zone (8) of the one conduction type which is adjacent to the drift zone (2) and, adjacent to the first well zone (8), a second highly doped well zone (9) which is of the other conduction type, opposite to the one conduction type, and is adjacent to the semiconductor substrate (1) are provided between the drift zone (2) and the semiconductor substrate (1).

2. IGBT according to Claim 1, **characterized in that** an IGBT cell (3) with a cathode (4, 5; K) and with an anode (6; A) which is arranged at the edge of the drift zone (2) and surrounds the IGBT cell (3) are provided in the drift zone (2).

3. IGBT according to Claim 1 or 2, **characterized in that** the two well zones (8, 9) are connected to one another on their surface by means of a short circuit strap (10).

4. IGBT according to Claim 1 or 2, **characterized in that** the two well zones (8, 9) and the semiconductor substrate (1) are connected to one another on their surfaces by a short-circuit strap (10, 11).

5. Method for manufacturing the well zones for the IGBT according to one of Claims 1 to 4, **characterized in that** horizontal regions of the well zones (8, 9) are manufactured by implantation and/or diffusion, and **in that** vertical regions of the well zones (8, 9) are manufactured by means of at least two epitaxial steps (14, 15) with subsequent implantation and/or diffusion.

6. Method for manufacturing the well zones for the IGBT according to one of Claims 1 to 4, **characterized in that** horizontal regions of the well zones (8, 9) are manufactured by means of implantation and/or diffusion, and **in that** vertical regions of the well zones (8, 9) are manufactured by means of trench etching (17, 18) in an epitaxial step (16) with subsequent filling of the trenches with doped polycrystalline silicon (19, 20) and diffusing out (cf. 21).

## Revendications

1. IGBT à isolement PN, comprenant une zone (2) de déplacement peu dopée d'un type de conductivité, prévue dans un substrat semiconducteur peu dopé de ce un type de conductivité,
**caractérisé,**
**en ce que** entre la zone (2) de déplacement et le substrat semiconducteur sont prévus une première zone (8) de caisson très dopée de ce un type de conductivité et s'appliquant à la zone (2) de déplacement et, s'appliquant à la première zone (8) de caisson, une deuxième zone (9) de caisson très dopée de l'autre type de conductivité opposé au un type de conductivité et s'appliquant au substrat (1) semiconducteur.

2. IGBT suivant la revendication 1,
**caractérisé,**
**en ce qu'**il est prévu dans la zone (2) de déplacement une cellule (3) IGBT ayant une cathode (4, 5; K) et une anode (6; A) disposée au bord de la zone (2) de déplacement et entourant la cellule (3) IGBT.

3. IGBT suivant la revendication 1 ou 2,
**caractérisé,**
**en ce que** les deux zones (8,9) de caisson sont reliées entre elles sur la surface par un étrier (10) de court circuit.

4. IGBT suivant la revendication 1 ou 2,
**caractérisé,**
**en ce que** deux zones (8,9) de caisson et le substrat (1) semi conducteur sont reliés entre eux sur la surface par un étrier (10,11) de court circuit.

5. Procédé de production des zones de caisson pour l'IGBT suivant l'une des revendications 1 à 4,
en ce que l'on produit des parties horizontales des zones (8,9) de caisson par implantation et/ou par diffusion et en ce que l'on produit des parties verticales des zones (8,9) de caisson par au moins deux stades (14, 15) d'épitaxie suivis d'une implantation et/ou d'une diffusion.

6. Procédé de production des zones de caisson pour l'IGBT suivant l'une des revendications 1 à 4,
**caractérisé,**
**en ce que** l'on produit les parties horizontales des zones (8, 9) de caisson par implantation et/ou par diffusion, et l'on produit les parties verticales des zones (8, 9) de caisson, en ménageant (17, 18) des sillons par attaque dans une couche (16) épitaxiale en faisant suivre d'un remplissage des sillons par du silicium (19, 20) polycristallin dopé et d'une diffusion (cf. 21).
